# EUROPEAN PATENT APPLICATION

(11) **EP 1 059 672 A2**
(43) Date of publication of application: **13.12.2000**
(21) Application number: 00112400.7
(22) Date of filing: 09.06.2000
(51) Int. Cl.: H01L 29/06, H01L 29/739, H01L 21/331

(54) **High withstand voltage semiconductor device and method of manufacturing the same**

(30) Priority: 10.06.1999 JP 16324399; 28.10.1999 JP 30734999
(71) Applicant: FUJI ELECTRIC CO., LTD., Kawasaki-shi, Kanagawa 210-0856 (JP)
(72) Inventor: Matsuzaki, Kasuo, c/o Fuji Electric Co., Ltd., Kawasaki-shi, Kanagawa 210-0856 (JP); Mikoshiba, Yasuharu, c/o Fuji Electric Co., Ltd., Kawasaki-shi, Kanagawa 210-0856 (JP); Fujiwara, Hitoshi, c/o Fuji Electric Co., Ltd., Kawasaki-shi, Kanagawa 210-0856 (JP)
(74) Representative: Grünecker, Kinkeldey, Stockmair & Schwanhäusser Anwaltssozietät

(57) **Abstract**

In the surface layer of an n-type semiconductor substrate 1, an n+ cathode region 2 and a p+ anode region 3 are formed, on which a cathode electrode 5 and an anode electrode 6 are formed, respectively. An oxide film 4 serving as a surface protection film is formed partially on the n+ cathode region 2, p+ anode region 3 and n-type semiconductor substrate 1 sandwiched by these regions. On the oxide film 4, a semi-insulating silicon nitride film 10 having a thickness of 1 µm is deposited by the plasma CVD technique. The film composition of the surface layer of the semi-insulating silicon nitride film 10 is changed into silicon nitride film (Si₃N₄) having a thickness of about 0.1 µm to form an insulating silicon nitride film 8. Then, the composition of the underlying semi-insulating silicon nitride film is not changed. The semi-insulating silicon nitride film serves as a field plate so that concentration of the electric field on the surface can be relaxed.

## Description

### BACKGROUND OF THE INVENTION

### 1. Field of the invention

The present invention relates to a high withstand voltage semiconductor device such as an IGBT (insulated gate type bipolar transistor) or a high withstand voltage power IC, and more particularly to realization of high withstand voltage of the surface thereof.

### 2. Description of the Related Art

Several attempts have been made for realization of a planar and high withstand voltage semiconductor device. The main attempt is to control a depletion layer in the vicinity of a planar junction. To this end, an improvement for relaxation of an electric field such as enlargement of the curvature at the junction and arrangement of a guard ring has been made.

An example thereof is an electrode structure for the purpose of relaxing surface electric field, i.e. a "over-oxide structure". The technique for optimizing it is disclosed in e.g. IEEE Trans. Electron Dev. ED-26, pp. 1098 (1979). There is also proposed a technique for relaxing the surface electric field by covering the area between an electrode and a surrounding guard ring with a resistive film so that the electric potential applied between the electrode and the surrounding guard ring is divided by the resistor (Solid-State Electronics, Vol. 15, pp.653 - 657 (1972).

In recent years, a technique of using a semi-insulating film instead of a resistive film has been proposed (e.g. IEEE Tran. on Electron Device, Vol. ED-23, No. 8, p826, August (1976)).

The resistive film which is a conventional technique is deposited by "electron beam evaporation" in which a silicon source is generally evaporated by electron beams. This technique is problematic from the viewpoint of wafer process in that a poor technique in source melting leads to abrupt vaporization because the silicon source is a refractory material to generate inconvenience such as production of a projection on the wafer surface. On the other hand, in the technique of using a semi-insulating film (SIPOS; Semi-Insulating Polycrystalline Silicon), the semi-insulating film is formed by reacting silane (SiH₄) and dinitrogen oxide (N₂O)in an atmosphere of N₂, through the reduced pressure CVD technique, generally at 600 °C. Therefore, in view of a problem of heat, the semi-insulating film cannot be deposited after an Al electrode has been formed, but it must be deposited before the Al electrode is formed. Further, it has been proposed to use a semi-insulating silicon nitride film by the plasma CVD taking advantage of that it can be formed at a low temperature (IEEE Tran. On Electron Device, Vol. 37, No. 6, p1522, June (1999)).

However, this technique may suffer from inconvenience that the semi-insulating silicon nitride film may be corroded in a reliability test after mold resin sealing. In order to obviate such inconvenience, it has been also proposed to protect the upper surface of the semi-insulating silicon nitride film by an insulating silicon nitride film. However, as the case may be, it is difficult to acquire a regenerative semi-insulating silicon nitride since the film composition of the underlying semi-insulating silicon nitride film is changed in the course of depositing the insulating silicon nitride film. Thus, the high withstand voltage semiconductor device having such an unstable semi-insulating silicon nitride film provide poor reliability in the withstand voltage characteristic.

In this case, in the course of deposition, since the semi-insulating silicon nitride film is exposed to the environment containing a large quantity of active hydrogen atoms, the active hydrogen atoms diffuse into the underlying semi-insulating silicon nitride film so that the film quality of the semi-insulating silicon nitride film is changed.

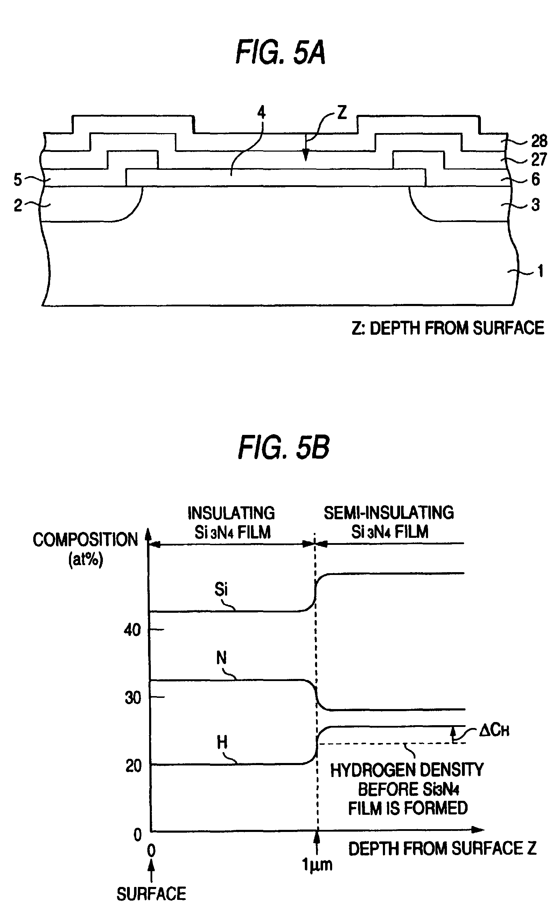

Fig. 5A is a sectional view of the main portion of a conventional high withstand voltage semiconductor device, and Fig. 5B is a distribution graph of composition elements of the semi-insulating silicon nitride film and insulating silicon nitride film, which have been deposited by the conventional technique.

More specifically, Fig. 5A is a sectional view of the main portion of a planar diode. In the surface layer of an n-type semiconductor substrate 1, an n+ cathode region 2 and a p+ anode region 3 are formed, on which a cathode electrode 5 and an anode electrode 6 are formed, respectively. An oxide film 4 serving as a surface protection film is formed partially on the n+ cathode region 2, p+ anode region 3 and n-type semiconductor substrate 1 sandwiched between these regions. On the oxide film 4, a semi-insulating silicon nitride film 27 and an insulating silicon nitride film 28, which are field plate films, are formed. The semi-insulating film 27 is deposited by the plasma CVD technique, and in order to assure the reliability, it is covered with the insulating silicon nitride film 28. The insulting silicon nitride film 28 is formed on the semi-insulating silicon nitride film 27 by the plasma CVD using silane (SiO₄) and ammonia (NH₃)or nitrogen (N₂).

As seen from Fig. 5B, when the deposition has been made as described above, the H atom density of the semi-insulating silicon nitride film 27 which is a first layer is changed (increase by Δ C_{H}) in the course of depositing the insulating silicon-nitride film which is a second layer so that the function of the semi-insulating film 27 as a resistive field plate is attenuated. As a result, the reliability of the withstand voltage characteristic of the high withstand voltage device is lowered. In Fig. 5B, Si denotes silicon, N denotes nitrogen, H denotes hydrogen and the density is represented by atomic %.

### SUMMARY OF THE INVENTION

An object of the invention is to provide a high withstand voltage semiconductor device which can solve the above problem and improve the reliability of the withstand voltage characteristic, and a method of manufacturing it.

In order to attain the above object, a high withstand voltage semiconductor device wherein a first region having a first conduction type and a second region having a second conduction type are formed in a surface layer of a semiconductor substrate having the first conduction type, comprises a semi-insulating film formed on the semiconductor substrate sandwiched between the first region and second region, and an insulating film formed on the semi-insulating film.

Preferably, the semi-insulating film is formed through an insulating layer on the semiconductor substrate.

Preferably, the semi-insulating film covers the first electrode formed on the first region, the second electrode formed on the second region and an edge of each of the first and the second electrode.

Preferably, the semi-insulating film contains at least Si, N and H atoms and the insulating film is a film formed by nitriding the semi-insulating film within nitrogen plasma.

Preferably, the insulating film is a film formed by nitriding the surface layer of the semi-insulating film within nitrogen plasma.

Preferably, the semi-insulating film contains at least Si, N and H atoms, and the insulating film is a film deposited by reactive sputtering not containing H atoms and containing at least Si and N atoms as main elements.

A method of manufacturing a high withstand voltage semiconductor device wherein a first region having a first conduction type and a second region having a second conduction type are formed in a surface layer of a semiconductor substrate having the first conduction type comprises the steps of forming a semi-insulating film containing at least Si, N and H atoms on the semiconductor substrate sandwiched between the first region and the second region and nitriding a surface layer of the semi-insulating film in an atmosphere of nitrogen plasma to form an insulating film.

A method of manufacturing a high withstand voltage semiconductor device wherein a first region having a first conduction type and a second region having a second conduction type are formed in a surface layer of a semiconductor substrate having the first conduction type comprises the steps: forming a semi-insulating film containing at least Si, N and H atoms on the semiconductor substrate sandwiched between the first region and the second region and forming an insulating film by the reactive sputtering technique not containing H and containing at least Si and N atoms as main elements.

Preferably, the manufacturing method comprises the steps of forming an insulating layer on the semiconductor substrate arid forming a semi-insulating film containing at least Si, N and H atoms on the insulating layer.

In this way, the insulating silicon nitride film used as a protection film can be formed in an atmosphere not containing active H atoms so that it can be formed without changing the film quality of the underlying semi-insulating silicon nitride film.

### BRIEF DESCRIPTION OF THE DRAWINGS

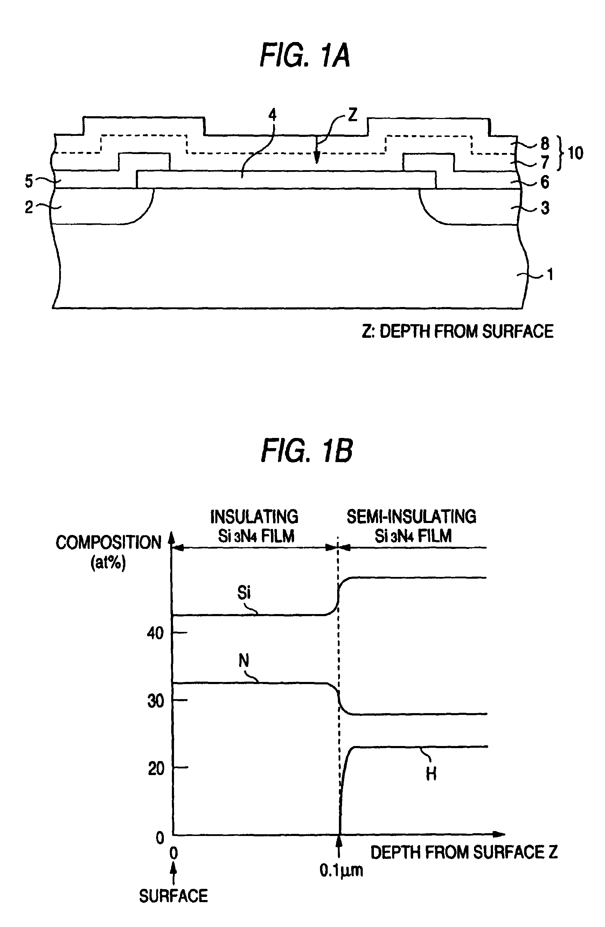

Fig. 1A is a sectional view of the main part of a high withstand voltage semiconductor device according to a first embodiment of the invention; and Fig. 1B is a distribution graph of composition elements in a depth direction of the semi-insulating film and insulating film according to the first embodiment of the invention.

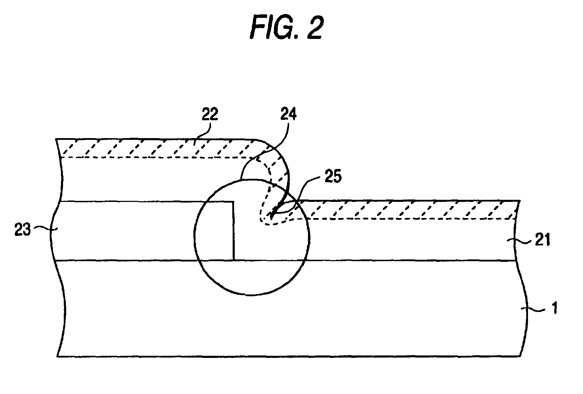

Fig. 2 is a sectional view of the high withstand voltage semiconductor device according to a second embodiment of the invention.

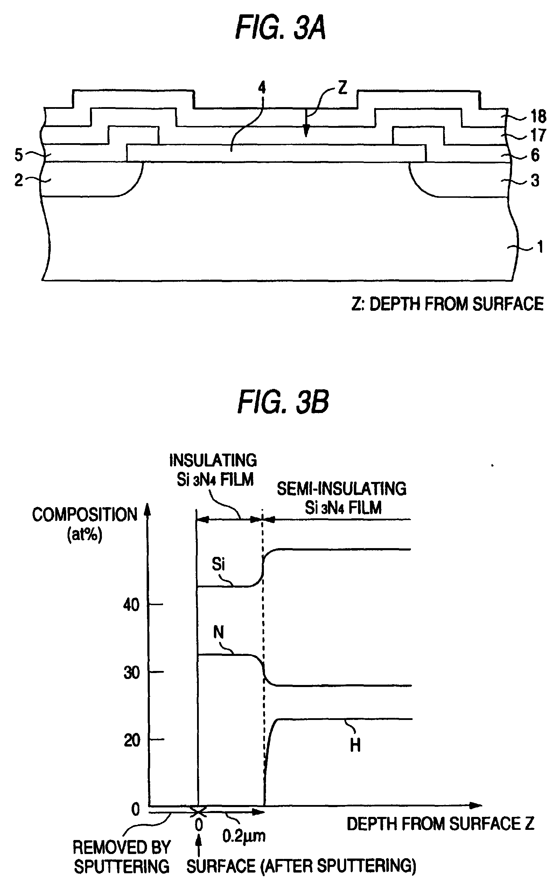

Fig. 3A is a sectional of the main part of a high withstand voltage semiconductor device according to a third embodiment of the invention; and Fig. 3B is a distribution graph of composition elements in a depth direction of the semi-insulating film and insulating film according to the third embodiment of the invention.

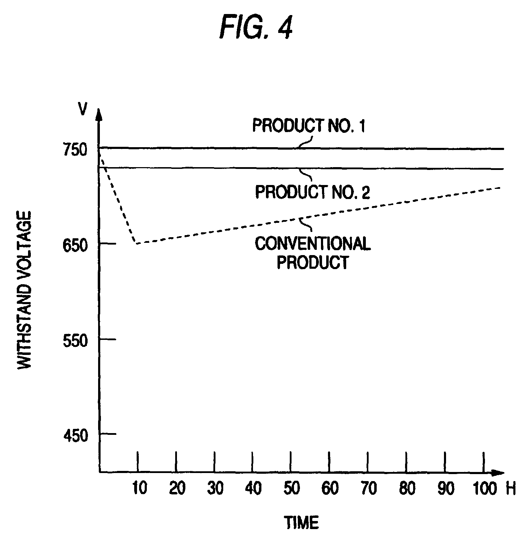

Fig. 4 is a graph showing the stability of the withstand voltage characteristic in the conventional product and first product and second product according to the invention.
Fig. 5A is a sectional of the main part of a conventional high withstand voltage semiconductor device; and Fig. 5B is a distribution graph of composition elements in a depth direction of the semi-insulating silicon nitride film and insulating silicon nitride film, which were deposited by a conventional manufacturing method.

### DETAILED DESCRIPTION OF THE PRESENT INVENTION

Figs. 1A and 1B show a first embodiment of the invention. Fig. 1A is a sectional of the main part of a high withstand voltage semiconductor device and Fig. 1B is a distribution graph of composition elements in a depth direction of the semi-insulating film and insulating film. Now, the semi-insulating film is referred to as a semi-insulating silicon nitride film and the insulating film is referred to as an insulating silicon nitride film.

The high withstand voltage semiconductor device illustrated here is a diode having a horizontal planar structure. However, this embodiment can be applied to a semiconductor device having a planar structure such as a horizontal or vertical MOSFET or IGBT.

In Fig. 1A, in the surface layer of an n-type semiconductor substrate 1, an n+ cathode region 2 and a p+ anode region 3 are formed, on which a cathode electrode 5 and an anode electrode 6 are formed, respectively. An oxide film 4 serving as a surface protection film is formed partially on the n+ cathode region 2, p+ anode region 3 and n-type semiconductor substrate 1 sandwiched between these regions. On the oxide film 4, a semi-insulating silicon nitride film 10 having a thickness of 1 µm is deposited by the plasma CVD technique under the condition of a substrate temperature of 32 °C, RF power of 1kw (50 kHz), in-chamber pressure of 53Pa during deposition, carrier gas of 1.55 SLM, gas flow rate R = SiH₄/(SiH₄ + NH₃) of 0.8.

After the semi-insulating silicon nitride film 10 having 1 µm is deposited, with gas exhausted from the environment, discharging is made in the environment of only an Ar carrier gas and N2 gas (1SLM) for 5 minutes. As a result, the film composition of the surface layer of the semi-insulating silicon nitride film 10 is changed into e.g. a stoichiometric silicon nitride film (Si₃N₄) having a thickness of 0.1 µm to form an insulating silicon nitride film 8.

In this case, it should be noted that the composition of the semi-insulating silicon nitride film 7 having a thickness of about 0.9 µm which is located beneath the insulating silicon nitride film 8 remains that of the semi-insulating silicon nitride film 10 before the insulating silicon nitride 7 is formed.

The presence of the insulating silicon nitride film 8 prevents the semi-insulating silicon nitride film 7 from being exposed to the environment.

As seen from Fig. 1B, under the condition of forming the insulating silicon nitride film 8 described in connection with Fig. 1A, the insulating silicon nitride film 8 can be formed without changing the film composition of the underlying semi-insulating silicon nitride film 7, particularly the density of H. The semi-insulating film silicon nitride film 7, whose composition does not almost change, serves as a field plate so that the intervals between equipotential lines in the depletion layer extended in the n-type semiconductor substrate 1 are equalized to relax the concentration of electric field in the surface. Since the semi-insulating silicon nitride film 7 is protected by the insulating silicon nitride film 8 so that it is not exposed to the environment, the reliability of the withstand voltage characteristic of the high withstand voltage semiconductor device can be greatly improved. In Figs. 1A and 1B, Si denotes silicon, N denotes nitrogen, H denotes hydrogen and the density is represented by atomic %. The analysis of the film composition was carried out by ESCA (Electron Spectroscopy for Chemical Analysis).

Fig. 2 is a sectional view of the high withstand voltage semiconductor device according to the second embodiment of the invention. The sectional view illustrates a level difference at the end of wiring.

By the plasma CVD, a semi-insulating SixNyHz film (R-SiN 21) which is a semi-insulating silicon nitride film is deposited on a n-type semiconductor substrate 1 and a wiring 23 made of aluminum. Thereafter, by the N₂ plasma processing, the surface layer of R-SiN 21 is reformed into an insulating SixNyHz (R-SiN+N 22) which is an insulating silicon nitride film.

The initial semi-insulating SixNyHz film (R-SiN 21) is deposited under the deposition condition of SiN₄ of 275 sccm, NH₃ of 100 sccm, carrier gas Ar of 1500 sccm, gas pressure of 0.4 Torr, substrate temperature of 320 °C, RF power of 0.38 kW (50 kHz), and deposition time of 205 sec. This provides the film thickness of 0. 1 µm.

Next, by the N2 plasma processing, the surface layer of the semi-insulating SixNyHz film (R-SiN 21) is reformed into the insulating SixNyHz (R-SiN+N 22). It is reformed under the condition of N₂ of 275 sccm, carrier gas N₂ of 1120 sccm, gas pressure of 0.4 torr., substrate temperature of 320 °C, RF power of 0. 38 kW (50 kHz) and deposition time of 2400 sec. This reforms the surface layer of the semi-insulating SixNyHz film (R-SiN 21) into the insulating SixNyHz (R-SiN+N 22) having a thickness of 0.018 µm.

For information, conventionally, the semi-insulating SixNyHz film (I-SiN) is deposited under the deposition condition of SiN₄ of 202 sccm, NH₃ of 380 sccm, carrier gas Ar of 1938 sccm, gas pressure of 0.4 Torr, substrate temperature of 300 °C, RF power of 0.36 kW (50 kHz), and deposition time of 20114 sec. The composition analysis by ESCA of the film thus deposited is shown in Table 1.

**Table 1**

| Sample | Si | N | H | Si: N |
|---|---|---|---|---|
| R-SiN+N2 | 50.0 | 48.0 | 2.0 | 1 : 0.96 |
| I-SiN | 60.0 | 36.0 | 4.0 | 1 : 0.6 |
| R-SiN | 75.0 | 15.0 | 10.0 | 1 : 0.2 |
| | Unit : at% | | | |

From Table 1, it can seen that the silicon nitride film (R-SiN+N₂ 22) containing a small quantity of H has been obtained through the N₂ plasma processing.

As a result, a crack 25, which is generated in the semi-insulating silicon nitride film (R-SiN 21) covering a step 24 at the tip of the wiring 23, can be reformed into the semi-insulating silicon nitride film (R-SiN+N₂ 22) by the N₂ plasma processing, which is brought into intimate contact with the semi-insulating silicon nitride film (R-SiN 21). This prevent moisture from invading into the step 24. This was confirmed by means of the KOH immersion test.

Figs. 3A and 3B shows a third embodiment of the invention. Fig. 3A is a sectional view of the main part of a high withstand voltage semiconductor device and Fig. 3B is a distribution graph of composition elements in a depth direction of the semi-insulating film and insulating film.

In this embodiment, as in the case of Fig. 1A, a semi-insulating silicon nitride film 17 having a thickness of 1 µm was formed by the plasma CVD technique under the same deposition condition as that of the first embodiment. This is different from the first embodiment in that an insulating silicon nitride film 18 having a thickness of 0.2 µm was stacked on the semi-insulating silicon nitride film 17 by the reactive sputtering using silicon as a target (sputtering condition of the target of Si, gas flow rate of R = N2/(N2 + Ar), pressure of 0.27 Pa, DC power of 2.5 lW and substrate temperature of 200 °C), namely, the insulting silicon nitride film 18 was stacked while etching the surface of the semi-insulating silicon nitride film. In this case also, the film composition of the underlying silicon nitride film 17 did not almost change.

As understood from the first and the third embodiment, it is important that the film composition of the semi-insulating silicon nitride film 7 (17) is not changed when the insulating silicon nitride film 8 (18) serving as a protection film is formed. Particularly, the insulating silicon nitride film 18 is preferred since it has properties such as great ion-resistant characteristic and mechanical strength. It is important that when the insulating silicon nitride film 18 is formed, H atoms are not taken into the underlying semi-insulating silicon nitride film 17.

Fig. 4 is a graph showing the comparison in stability of the withstand voltage between the planar diode (conventional product) using a conventional double layer structure composed of a semi-insulating silicon nitride film and an insulating silicon nitride film, and the planar diode (first product according to the invention) using the first embodiment and planar diode (second product according to the invention) according to the third embodiment. These planar diodes are sealed by resin molding.

The stability in the withstand voltage characteristic was tested by the high-temperature high-voltage applying test under the condition of an applying voltage of 530 V and a temperature of 125 °C. As seen from the graph, in the conventional product, the withstand voltage lowers once after the test is started, while in the products according to the first and the second embodiment, such inconvenience does not occur.

In accordance with the invention, the surface layer of the semi-insulating silicon nitride film is reformed into the insulating silicon nitride film while the composition of the underlying semi-insulating silicon nitride film is maintained so that the semi-insulating silicon nitride film is not exposed to an external environment. Thus, it is possible to prevent concentration of the electric filed on the surface for a long time and greatly improve the reliability for the withstand voltage characteristic of the semiconductor device.

## Claims

1. A high withstand voltage semiconductor device comprising:
a semiconductor substrate having a first conduction type, the semiconductor substrate having a surface layer;
a first region having the first conduction type, the first region formed in the surface layer of the semiconductor substrate;
a second region having a second conduction type, the second region formed in the surface layer of the semiconductor substrate;
a semi-insulating film containing at least Si, N, and H atoms formed on the semiconductor substrate sandwiched between the first region and second region; and
an insulating film formed by nitriding a surface layer of the semi-insulating film in an atmosphere of nitrogen plasma.

2. A high withstand voltage semiconductor device comprising:
a semiconductor substrate having a first conduction type, the semiconductor substrate having a surface layer;
a first region having the first conduction type, the first region formed in the surface layer of the semiconductor substrate;
a second region having a second conduction type, the second region formed in the surface layer of the semiconductor substrate;
a semi-insulating film containing at least Si, N, and H atoms formed on the semiconductor substrate sandwiched between the first region and second region; and
an insulating film deposited by reactive sputtering not containing H atoms on the semi-insulating film, the insulating film containing at least Si and N atoms as main elements.

3. The high withstand voltage semiconductor device according to claim 1, further comprising an insulating layer disposed between the semiconductor substrate and the semi-insulating film.

4. The high withstand voltage semiconductor device according to claim 2, further comprising an insulating layer disposed between the semiconductor substrate and the semi-insulating film.

5. The high withstand voltage semiconductor device according to claim 1, further comprising:
a first electrode formed on the first region; and
a second electrode formed on the second region,
wherein the semi-insulating film and the insulating film are formed to cover the first electrode and the second electrode.

6. The high withstand voltage semiconductor device according to claim 2, further comprising:
a first electrode formed on the first region; and
a second electrode formed on the second region,
wherein the semi-insulating film and the insulating film are formed to cover the first electrode and the second electrode.

7. The high withstand voltage semiconductor device according to claim 3, further comprising:
a first electrode formed on the first region; and
a second electrode formed on the second region,
wherein the first electrode and the second electrode cover an edge of the insulating layer, and the semi-insulating film and the insulating film are formed to cover the first electrode and the second electrode.

8. The high withstand voltage semiconductor device according to claim 4, further comprising:
a first electrode formed on the first region; and
a second electrode formed on the second region,
wherein the first electrode and the second electrode cover an edge of the insulating layer, and the semi-insulating film and the insulating film are formed to cover the first electrode and the second electrode.

9. A method of manufacturing the high withstand voltage semiconductor device according to claim 1, comprising the steps of:
forming a semi-insulating film by the plasma CVD technique using SiN₄ and NH₃ as a reactive gas; and
nitriding a surface layer of the semi-insulating film in an atmosphere of nitrogen plasma to form an insulating film.

10. A method of manufacturing the high withstand voltage semiconductor device according to claim 3, comprising the steps of:
forming a semi-insulating film by the plasma CVD technique using SiN₄ and NH₃ as a reactive gas; and
nitriding a surface layer of the semi-insulating film in an atmosphere of nitrogen plasma to form an insulating film.

11. A method of manufacturing the high withstand voltage semiconductor device according to claim 5, comprising the steps of:
forming a semi-insulating film by the plasma CVD technique using SiN₄ and NH₃ as a reactive gas; and
nitriding a surface layer of the semi-insulating film in an atmosphere of nitrogen plasma to form an insulating film.

12. A method of manufacturing the high withstand voltage semiconductor device according to claim 7, comprising the steps of:
forming a semi-insulating film by the plasma CVD technique using SiN₄ and NH₃ as a reactive gas; and
nitriding a surface layer of the semi-insulating film in an atmosphere of nitrogen plasma to form an insulating film.

13. A method of manufacturing the high withstand voltage semiconductor device according to claim 2, comprising the steps of:
forming a semi-insulating film by the plasma CVD technique using SiN₄ and NH₃ as a reactive gas; and
forming an insulating film in an atmosphere of a reactive gas of only N₂ by the reactive sputtering technique using silicon as a target.

14. A method of manufacturing the high withstand voltage semiconductor device according to claim 4, comprising the steps of:
forming a semi-insulating film by the plasma CVD technique using SiN₄ and NH₃ as a reactive gas; and
forming an insulating film in an atmosphere of a reactive gas of only N₂ by the reactive sputtering technique using silicon as a target.

15. A method of manufacturing the high withstand voltage semiconductor device according to claim 6, comprising the steps of:
forming a semi-insulating film by the plasma CVD technique using SiN₄ and NH₃ as a reactive gas; and
forming an insulating film in an atmosphere of a reactive gas of only N₂ by the reactive sputtering technique using silicon as a target.

16. A method of manufacturing the high withstand voltage semiconductor device according to claim 8, comprising the steps of:
forming a semi-insulating film by the plasma CVD technique using SiN₄ and NH₃ as a reactive gas; and
forming an insulating film in an atmosphere of a reactive gas of only N₂ by the reactive sputtering technique using silicon as a target.
